# EUROPÄISCHE PATENTSCHRIFT

(11) **EP 2 541 623 B1**
(45) Veröffentlichungstag und Bekanntmachung des Hinweises auf die Patenterteilung: **14.12.2016**
(21) Anmeldenummer: 11005332.9
(22) Anmeldetag: 30.06.2011
(51) Int. Cl.: H01L 31/05

(54) **Lichtkonverter**
Light converter
Convertisseur de lumière

(43) Veröffentlichungstag der Anmeldung: 02.01.2013
(73) Patentinhaber: AZURSPACE Solar Power GmbH, 74072 Heilbronn (DE)
(72) Erfinder: Löckenhoff, Rüdiger, Dr., 74321 Bietigheim-Bissingen (DE); Rasch, Klaus-Dieter, Dr., 74226 Nordheim (DE)
(74) Vertreter: Koch Müller Patentanwaltsgesellschaft mbH

(56) Entgegenhaltungen:
- EP-A1- 2 086 023
- DE-A1- 1 927 387
- DE-A1-102008 046 329
- US-A- 3 973 996
- US-A- 4 617 420
- US-A1- 2010 275 976
- US-A1- 2011 132 451

## Beschreibung

Die Erfindung betrifft einen Lichtkonverter gemäß dem Oberbegriff des Patentanspruchs 1.

Aus der US 6 532 653 B1 ist ein Lichtkonverter offenbart, bei dem eine Vielzahl von reihenförmig angeordneten Solarzellen in Serie verschaltet sind. Innerhalb einer Reihe sind die einzelnen Solarzellen parallel auf leitfähigen Schichten angeordnet und mit den Schichten elektrisch verschaltet. Um eine Serienverschaltung von einer Reihe zu einer unmittelbar benachbarten Reihe auszubilden, umfasst ein U-förmiger Verbinder sowohl die Oberfläche einer Solarzelle als auch die rückseitige Fläche der gleichen Solarzelle. Auf der rückseitigen Fläche ist zwischen dem Verbinder eine Isolationsschicht ausgebildet, um einen Kurzschluss zwischen Vorderseite und Rückseite des jeweiligen Halbleiterkörper zu vermeiden. Um die einzelnen leitfähigen Schichten voneinander zu isolieren, werden auf der Rückseite der einzelnen Solarzelle zwischen dem U-förmigen Verbinder und der restlichen Rückseite Silikonformstücke ausgebildet.

Des Weiteren sind aus der US 2010 / 275976 A1, der DE 10 2008 046329 A1, der US 2011 /132451 A1, der US 3 973 996 und der DE 19 27 387 A1 unterschiedliche photovoltaische Module bekannt. Insbesondere offenbart die US 2010 /275976 A1 mechanische Verbinder, welche mit einer elektrisch isolierenden vorzugsweise optisch transparenten Folie einseitig beschichtet sind. Auf der Folie ist eine Klebeschicht aufgebracht, wobei aus der Klebeschicht Drähte hervorstehen, welche eine niedrig schmelzende Legierung aufweisen, um die Oberfläche oder die Rückseite der Solarzelle elektrisch mit den Drähten zu verbinden. Um eine Serienschaltung von einzelnen Solarzellen zu erzielen, werden die Drähte des ersten Verbinders, mit denen die Oberfläche elektrisch kontaktiert wird, mit den Drähten des zweiten Verbinders, mit denen die Rückseite elektrisch kontaktiert wird, mittels eines Sammelleiters elektrisch verschaltet. Der Sammelleiter ist auf der Rückseite der Solarzellen zwischen dem ersten Verbinder und dem zweiten Verbinder ausgebildet.

Vor diesem Hintergrund besteht die Aufgabe der Erfindung darin, eine Vorrichtung anzugeben, die jeweils den Stand der Technik weiterbildet.

Die Aufgabe wird durch einen Lichtkonverter mit den Merkmalen des Patentanspruchs 1 gelöst. Vorteilhafte Ausgestaltungen der Erfindung sind Gegenstand von Unteransprüchen. Gemäß dem Gegenstand der Erfindung wird ein Lichtkonverter, ausgebildet zur photovoltaischen Konvertierung von Licht bereitgestellt, mit einem Träger mit einer Vorderfläche und Rückfläche, und einem ersten Halbleiterkörper mit einer ersten Oberfläche und einer ersten rückseitigen Fläche, wobei die erste rückseitige Fläche auf der Vorderfläche des Trägers angeordnet ist, und einem zweiten Halbleiterkörper mit einer zweiten Oberfläche und einer zweiten rückseitigen Fläche, wobei die zweite rückseitige Fläche auf der Vorderfläche des Trägers angeordnet ist, und die erste Oberfläche des ersten Halbleiterkörpers mit der zweiten rückseitigen Fläche des zweiten Halbleiterkörpers verschaltet ist, und die erste Oberfläche und die zweite Oberfläche als Empfangsflächen für Licht ausgebildet sind, wobei ein elektrisch leitender Verbinder mit einem ersten Schenkel und einem zweiten Schenkel vorgesehen ist und der erste Schenkel auf der ersten Oberfläche angeordnet und mit der ersten Oberfläche verschaltet ist und der zweite Schenkel unter der zweiten rückseitigen Fläche angeordnet und mit der zweiten rückseitigen Fläche verschaltet ist, indem der zweite Schenkel in einem leitfähigen Material wenigstens teilweise eingebettet ist und das leitfähige Material zwischen der zweiten rückseitigen Fläche und einer zweiten Leiterbahnschiene angeordnet ist und die zweite Leiterbahnschiene als Teil des Trägers ausgebildet ist. Es sei angemerkt, dass der Träger vorzugsweise als PCB-Platine, insbesondere als keramische Platine mit Dickschicht Leiterbahnen, ausgebildet ist. Die Leiterbahnschiene lässt sich unter anderem als Beschichtung auf der Platine ausbilden. Eine andere Variante ist die Herstellung der Platine nach dem "Direct Copper Bonding (DCB)" Verfahren.

Ein Vorteil ist, dass sich mittels der erfindungsgemäßen Vorrichtung auf sehr einfache und kostengünstige Weise eine Serienfertigung von Lichtkonvertern mit einer Vielzahl von in Serie geschalteten Halbleiterkörpern ausbilden lässt. Vorzugsweise sind die Halbleiterkörper hierbei als Solarzellen ausgebildet. Insbesondere eignet sich die Verbindungsart mittels eines schenkelartigen Verbinders für eine kostengünstige und zuverlässige Serienfertigung von Solarzellenmodulen aus Solarzellen insbesondere der III-V Gruppe. Insbesondere haben Untersuchungen der Anmelderin gezeigt, dass sich mit der neuartigen Verbindungstechnik überraschenderweise ein einfaches sequentielles reihenförmiges Aufbringen der Halbleiterkörper erzielen lässt. Hierbei werden zunächst ein erster Schenkel eines ersten Verbinders mit einem ersten Halbeiterkörper sowie ein erster Schenkel des zweiten Verbinders mit einem zweiten Halbleiterkörper verbunden. Die Halbleiterkörper werden nun derart angeordnet, dass der zweite Halbleiterkörper einen zweiten Schenkel des ersten Verbinders überdeckt. Die elektrische Verschaltung erfolgt durch das leitfähige Material.

Im Unterschied zu dem Stand der Technik aus der US 6 532 653 B1 entfällt die aufwändige Herstellung von Halbleiterkörpern mit zwei voneinander isolierten, einander überdeckenden metallischen Rückseitenkontakten an der jeweiligen rückseitigen Fläche eines Halbleiterkörpers. Des Weiteren muss der U-förmige Verbinder eng um die Solarzellenkante geführt und sowohl auf der Frontseite als auch zusätzlich auf der Rückseite verschweißt werden. Bei der Verschweißung auf der Rückseite besteht die Gefahr, dass die Isolationsschicht zwischen den sich überdeckenden Metallschichten beschädigt wird. Ferner entfällt die aufwändige Anbringung des U-förmigen Verbinders.

Es sei angemerkt, dass der Verbinder niederohmig, vorzugsweise aus einem Metall, höchst vorzugsweise aus Silber oder einer Silberverbindung, auszuführen ist, um Stromstärken von bis zu 25 Ampere je Halbleiterkörper mit geringer Verlustleistung zu leiten.

In einer Weiterbildung benetzt das leitfähige Material die zweite rückseitige Fläche des zweiten Halbleiterkörpers im Wesentlichen ganzflächig und bildet hierbei sowohl eine stoffschlüssige Verbindung zwischen dem zweiten Halblelterkörper und dem leitfähigen Material als auch eine stoffschlüssige Verbindung zwischen dem leitfähigen Material und der zweiten Leiterbahnschiene aus. Hierdurch wird eine besonders niederohmige Verbindung zwischen dem Halbleiterkörper und der zweiten Leiterbahnschiene erzielt. Insbesondere ist es bevorzugt, dass das zweite leitfähige Material ein Lot oder ein leitfähiges Polymer umfasst.

In einer anderen Weiterbildung ist zwischen dem ersten Schenkel und dem zweiten Schenkel ein Zwischenstück angeordnet. Der Verbinder weist im Querschnitt im Wesentlichen eine z-förmige oder stufenförmige Ausbildung auf. Es ist bevorzugt, dass der Normalenvektor auf der Oberfläche des ersten Schenkels im Wesentlichen parallel zu dem Normalenvektor des zweiten Schenkels ausgerichtet ist, sodass die Höhendifferenz zwischen den beiden Schenkeln im Wesentlichen durch die Länge des Zwischenstücks und dessen Abkantwinkel zu dem ersten und dem zweiten Schenkel bedingt ist.

In einer vorteilhaften Weiterbildung weist der Verbinder einen breiten zweiten Schenkel und mehrere erste Schenkel in einer kammförmigen Anordnung auf. Die mehreren ersten Schenkel übernehmen jeder für sich die Funktion eines Stromsammlers für die von der ersten Oberfläche ableitbaren Ströme. Hierdurch lässt sich mittels eines einzelnen Verbinders die erste Oberfläche des ersten Halbleiterkörpers an mehreren Stellen, vorzugsweise drei Stellen, niederohmig anschließen und niederohmig mit der zweiten rückseitigen Fläche verbinden. Alternativ lässt sich die erste Oberfläche auch mit mehreren, vorzugsweise streifenförmig ausgebildeten Verbindern mit der zweiten rückseitigen Fläche verschalten. Hierbei entspricht die Breite des Zwischenstücks vorzugsweise im Wesentlichen der Breite des ersten Schenkels und des zweiten Schenkels.

Gemäß einer bevorzugten Ausführungsform ist der Verbinder einstückig ausgebildet, wobei der zweite Schenkel wenigstens teilweise in ein Lotkissen eingebettet ist. Weiterhin bevorzugt ist, dass der erste Schenkel oder die mehreren ersten Schenkel mit der ersten Oberfläche verschweißt sind, während der zweite Schenkel vorzugsweise mit der zweiten rückseitigen Fläche verlötet ist.

Gemäß einer anderen Ausführungsform, weist die Oberfläche des Trägers im Bereich der ersten rückseitigen Fläche, zusätzlich zu der zweiten Leiterbahnschiene, eine erste Leiterbahnschiene auf, wobei die erste Leiterbahnschiene und die zweite Leiterbahnschiene voneinander beabstandet und elektrisch isoliert ausgebildet sind, auf. Mittels der schienenartigen Ausführung lassen sich eine Vielzahl von Halbleiterkörpern oder Solarzellen reihenförmig auf jeder der Schienen elektrisch parallel verschaltet anordnen. Des Weiteren ist es vorteilhaft, an den Schienen Dioden zum Schutz der Halbleiterkörper insbesondere vor Überspannungen und / oder elektronische Komponenten anzuordnen. Indem die Halbleiterkörper mittels der Verbinder mit der zweiten Schiene elektrisch verbunden sind, lässt sich mittels einer Aneinanderreihung von mehreren Schienen leicht eine modulartige Ausführung herstellen und bei einem Lichteinfall auf die Oberfläche der Halbleiterkörper eine hohe Spannung erzeugen.

In einer anderen Weiterbildung ist das leitfähige Material oder das Lotkissen zusätzlich zu der zweiten Leiterbahnschiene auch auf der ersten Leiterbahnschiene ausgebildet. Hierbei ist es bevorzugt, die erste rückseitige Fläche und die zweite rückseitige Fläche stoffschlüssig, vorzugsweise ganzflächig mit den jeweiligen Lotkissen zu verbinden.

Weiterhin ist es bevorzugt, die laterale Ausdehnung des jeweiligen Lotkissens geringfügig kleiner als die laterale Ausdehnung der rückseitigen Fläche des jeweiligen Halbleiterkörpers auszubilden, d. h. einen schmalen Randbereich nicht mit Lot zu benetzen und hierdurch die Anzahl der Kürzschlüsse zwischen der Oberfläche mit der rückseitigen Fläche des jeweiligen Halbleiterkörpers zu unterdrücken. In einer anderen Ausführungsform ist die erste rückseitige Fläche und die zweite rückseitige Fläche in einem Randbereich derart ausgebildet sind, dass der jeweilige Randbereich nicht mit Lot benetzt. Hierbei lässt sich der jeweilige Randbereich mechanisch und / oder chemisch behandeln und / oder mit einem Lötstoppmittel versehen, um eine Benetzung mit Lot zu unterdrücken.

Insbesondere ist es bevorzugt, dass der erste Halbleiterkörper eine quaderförmige Ausbildung aufweist und die Seitenflächen des Halbleiterkörpers mit einem Lötstoppmittel versehen sind, welches die Benetzung der Kanten mit Lot unterdrückt. Hierdurch lassen sich Kurzschlüsse zwischen den Kantenflächen der Halbleiterkörper und den Verbindern sowie zwischen den Kantenflächen verschiedener Halbleiterkörper vermeiden.

Des Weiteren ist es bevorzugt, dass der Verbinder auf mindestens einer Seite teilflächig, vorzugsweise zumindest an der Unterseite mit einem Lötstoppmlttel beschichtet ist. Hierdurch wird auf der Unterseite einen Benetzung mit dem leitfähigen Material unterdrückt und Kurzschlusse zwischen benachbarten Oberflächen von Halbleiterkörper vermieden. Vorzugsweise umfassen das Lötstoppmittel, ein Polymer und sind elektrisch isolierend und weisen eine Temperaturstabilität von mehreren 100°C auf. Es sei angemerkt, dass in einer alternativen Ausführungsform für die Kantenflächen und für den Verbinder und für die Unterseiten jeweils unterschiedliche Arten von Lötstoppmittel verwenden werden. Insbesondere ist vorgesehen, dass wenigstens eine Art von Lötstoppmittel ein Metalloxid, vorzugsweise auch ein Schichtsystem aus einer Metallschicht mit einer oberflächlichen Metalloxidschicht umfasst.

Indem der erste Halbleiterkörper und der zweite Halbleiterkörper seriell verschaltet sind, addieren sich bei einem Einfall von Licht auf die Empfangsflächen des ersten Halbleiterkörpers und des zweiten Halbleiterkörpers die photovoltaisch erzeugten Spannungen. Untersuchungen der Anmelderin haben gezeigt, dass sich die zu einem Array seriell verschalteten Halbleiterkörper bevorzugt in einer Konzentratoranordnung zur Erzeugung von Strom verwenden lassen. Hierbei wird der Lichtkonverter mit den Empfangsflächen im der Brennfläche einer das Sonnenlicht konzentrierenden Optik angeordnet. Insbesondere ist vorgesehen, dass die Empfangsflächen in Richtung des einfallenden Sonnenlichtes oberhalb einer Spiegelanordnung in der Brennfläche der Konzentratoranordnung angeordnet sind und der Lichtkonverter mit der Spiegelanordnung mechanisch starr gekoppelt ist, so dass bei einer Nachführung der Spiegelanordnung der Lichtkonverter mitgeführt wird.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: einen schematischen Querschnitt auf eine erfindungsgemäße Ausführungsform eines Lichtkonverters,
- Figur 2: eine schematische Draufsicht auf eine erste Ausführungsform einer Serlenverschaltung von mehreren Halbleiterkörpern des Lichtkonverters der Figur 1,
- Figur 3: eine schematische Draufsicht auf einer zweite Ausführungsform einer Serienschaltung von mehreren Halbleiterkörpern des Lichtkonverters der Figur 1.

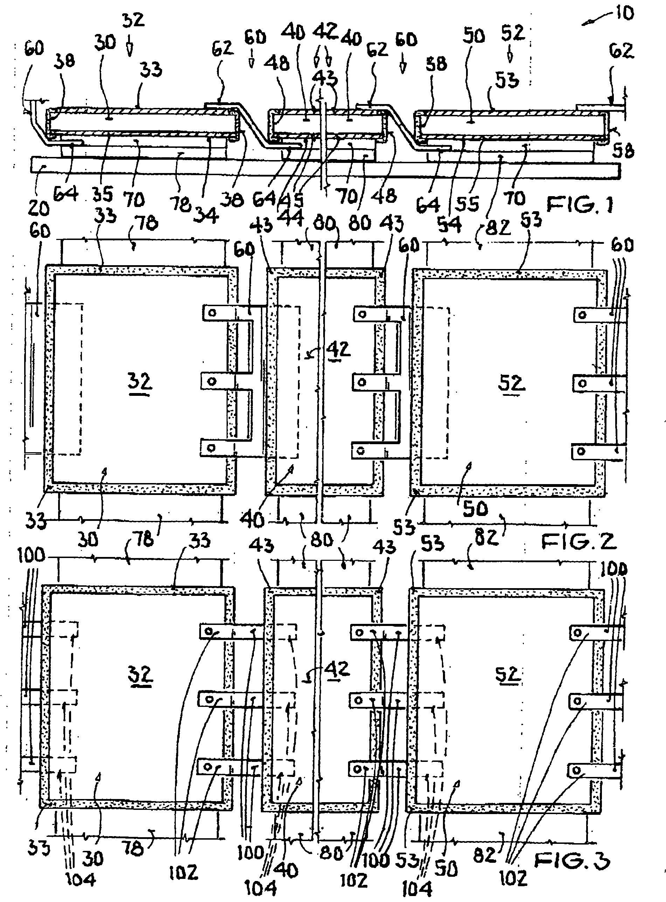

Die Abbildung der Figur 1 zeigt einen schematischen Querschnitt auf einen Lichtkonverter 10, mit einem Träger 20 mit einer Vorderfläche und Rückfläche, und einem ersten Halbleiterkörper 30 aufweisend, eine erste Oberfläche 32 mit einer auf der ersten Oberfläche 32 ausgebildeten ersten Randfläche 33, einer ersten rückseitigen Fläche 34 mit einer auf der ersten rückseitigen Fläche 34 ausgebildeten ersten rückseitigen Randfläche 35, wobei die erste rückseitige Fläche 34 auf der Vorderfläche des Trägers 20 angeordnet ist, und einer ersten umlaufenden Seitenfläche 38. Des Weiteren ist ein zweiter Halbleiterkörper 40 vorgesehen, aufweisend eine zweite Oberfläche 42 mit einer auf der zweiten Oberfläche 42 ausgebildeten Randfläche 43, eine zweiten rückseitigen Fläche 44 mit einer auf der zweiten rückseitigen Fläche 44 ausgebildeten zweiten rückseitigen Randfläche 45, wobei die zweite rückseitige Fläche 44 auf der Vorderfläche des Trägers 20 angeordnet ist, und eine zweiten umlaufenden Seitenfläche 48. Ferner ist ein dritter Halbleiterkörper 50 vorgesehen, aufweisend eine dritte Oberfläche 52 mit einer auf der dritten Oberfläche 52 ausgebildeten dritten Randfläche 53, eine dritten rückseitigen Fläche 54 mit einer an der dritten rückseitigen Fläche ausgebildeten dritten rückseitigen Randfläche 55, wobei die dritte rückseitige Fläche 54 auf der Vorderfläche des Trägers 20 angeordnet ist, und eine dritten umlaufenden Seitenfläche 58. Auf der ersten Oberflächen 32, der zweiten Oberflächen 42 und der dritten Oberflächen 52 sind die ersten Randflächen 33, die zweiten Randfläche 43 und die dritten Randflächen 53 umlaufend ausgebildet- nicht dargestellt. Des Weiteres sind auf der ersten rückseitigen Fläche 34, der zweiten rückseitigen Fläche 44 und den dritten rückseitigen Fläche 54 sind die ersten Randflächen 35, die zweiten Randfläche 45 und die dritten Randflächen 55 umlaufend ausgebildet- nicht dargestellt.

Des Weiteren sind die erste Oberfläche 32, die zweite Oberfläche 42 und die dritte Oberfläche 52 als Empfangsflächen für Licht ausgebildet. Insbesondere stellen die Halbleiterkörper 30, 40 und 50 Solarzellen dar.

Die erste Oberfläche 32 des ersten Halbleiterkörpers 30 ist mit der zweiten rückseitigen Fläche 44 des zweiten Halbleiterkörpers 40 mittels eines elektrisch leitenden Verbinders 60 in Serie verschaltet. Des Weiteren ist die zweite Oberfläche 42 des zweiten Halbleiterkörpers 40 mit der dritten rückseitigen Fläche 54 des dritten Halbleiterkörpers 50 mittels des elektrisch leitenden Verbinders 60 ebenfalls in Serie verschaltet. Hierdurch lassen sich die zwischen der Oberfläche und der rückseitigen Fläche der einzelnen Halbleiterkörper photovoltaisch erzeugten Spannungen addieren.

Der Verbinder 60 weist einen ersten Schenkel 62 und einem zweiten Schenkel 64 auf, wobei der erste Schenkel 62 auf der ersten Oberfläche 32 angeordnet und mit der ersten Oberfläche 32 verschaltet ist. Der zweite Schenkel 64 ist unter der zweiten rückseitigen Fläche 44 angeordnet und mit der zweiten rückseitigen Fläche 44 niederohmig verschaltet. Hierzu ist der zweite Schenkel 64 in einem leitfähigen Material 70 wenigstens teilweise eingebettet. Außerdem verschaltet ein weiterer Verbinder 60 die zweite Oberfläche 42 mit der dritten rückseitigen Fläche 54. Hierbei ist der zweite Schenkel 64 des weiteren Verbinders 60 unter der dritten rückseitigen Fläche 54 angeordnet. Anders ausgedrückt wird mittels der Verbinders 60 jeweils eine Serienschaltung zwischen zwei Halbleiterkörper ausgebildet. Untersuchungen der Anmelderin haben gezeigt, dass für die Ausbildung einen zuverlässigen niederohmigen Verbindung vorteilhaft ist, den ersten Schenkel mit der jeweiligen Oberfläche 32, 42 und 52 zu verschweißen und hierdurch einen niederohmigen elektrischen Anschluss mit der jeweiligen Oberfläche 32, 42 und 52 zu erzielen.

Das leitfähige Material 70, welches vorzugsweise als Lotkissen ausgebildet ist, ist zwischen der ersten rückseitigen Fläche 34 und einer ersten Leiterbahnschiene 78, zwischen der zweiten rückseitigen Fläche 44 und der zweiten Leiterbahnschiene 80 und zwischen der dritten rückseitigen Fläche 54 und der dritten Leiterbahnschiene 82 angeordnet. Das leitfähige Material bildet einerseits eine stoffschlüssige Verbindung mit den jeweiligen rückseitigen Flächen 34, 44 und 54 und andererseits mit den Leiterbahnschienen 78, 80 und 82, welche den rückseitigen Flächen zugeordnet sind, aus. Hierbei ist es bevorzugt, die rückseitigen Flächen bis auf die schmalen Randflächen oder anders ausgedrückt bis auf die Randbereiche vollständig mit dem leitfähigen Material 70 zu benetzen, um einen nahezu vollflächig thermisch leitenden und möglichst niederohmigen Anschluss der gesamten rückseitigen Fläche des jeweiligen Halbleiterkörpers mit der zugeordneten Leiterbahnschiene, zu erzielen. Um eine Benetzung mit dem leitfähigen Material 70 zu unterdrücken, sind die Randflächen auf der jeweiligen Oberfläche und den jeweiligen rückseitigen Flächen, sowie den Seitenflächen der einzelnen Halbleiterkörper besonders ausgeformt oder ausgebildet. Vorzugsweise weisen die Randbereiche und die Seitenflächen elektrisch isolierende, insbesondere als Polymer, ausgebildete Stoppmittel bzw. Lötstoppmittel auf. Indem eine Benetzung für das leitfähige Material unterdrückt wird, lässt sich ein Kurzschluss bei der Herstellung von Modulen und dem Verlöten zwischen der jeweiligen Oberfläche und der rückseitigen Fläche des jeweiligen Halbleiterkörpers unterdrücken.

Die erste Leiterbahnschiene 78, die zweite Leiterbahnschiene 80 und die dritte Leiterbahnschiene 82 sind vorzugsweise als Teil des Trägers 20 ausgebildet und zueinander mittels eines isolierenden Zwischenstreifens beabstandet. Hierbei verlaufen die Längsachsen der ersten Leiterbahnschiene 78, der zweiten Leiterbahnschiene 80 und der dritten Leiterbahnschiene 82 in die Zeichenebene hinein und sind ausgebildet, entlang der Längsachsen eine Vielzahl von Halbleiterkörpern oder Solarzellen aufzunehmen und möglichst niederohmig miteinander parallel zu verbinden. Die Schienen sind mittels der Verbinder 60 und den Halbleiterkörpern in einer Serienschaltung miteinander verschaltet.

In der Figur 2 ist eine schematische Draufsicht auf eine erste Ausführungsform einer Serienverschaltung von mehreren Halbleiterkörpern des Lichtkonverters der Figur 1 dargestellt. Nachfolgend werden nur die Unterschiede zu der Ausführungsform, dargestellt in der Figur 1, erläutert. Nunmehr ist sichtbar, dass die ersten Randflächen 33, die zweiten Randfläche 43 und die dritten Randflächen 53 auf den ersten Oberflächen 32, den zweiten Oberflächen 42 und den dritten Oberflächen 52 umlaufend ausgebildet sind. Die jeweiligen Oberflächen sind jeweils mit dem Verbinder 60, aufweisend einen breiten zweiten Schenkel 63 und drei erste Schenkel 62, welche kammförmig angeordnet sind, niederohmig mit einer benachbarten rückseitigen Fläche angeschlossen. Jeder der drei ersten Schenkel 62 weist am Ende einen Schweißpunkt auf, d.h. ist mit der Oberfläche verscheißt. Hierzu weisen die Oberflächen unter den Endstücken der ersten Schenkel eine entsprechende Metallfläche auf.

In der Figur 3 ist eine schematische Draufsicht auf eine zweite Ausführungsform einer Serienverschaltung von mehreren Halbleiterkörpern des Lichtkonverters der Figur 1 dargestellt. Nachfolgend werden nur die Unterschiede zu der Ausführungsform, dargestellt in der Figur 2, erläutert. Die jeweiligen Oberflächen der Halbleiterkörper sind mit anstelle des einzelnen breiten Verbinders 60 drei einzelnen Verbinder 100, welche streifenförmig ausgebildet sind, und einen ersten Schenkel 102 und einen zweiten Schenkel 104 aufweisen, mit der nachfolgenden rückseitigen Fläche niederohmig verschaltet. Jeder der ersten Schenkel 102 weist einen Schweißpunkt zum Anschluss des ersten Schenkels 102 mit der unterliegenden auf der jeweiligen Oberfläche angeordneten Metallfläche - nicht dargestellt - auf.

## Patentansprüche

1. Lichtkonverter (10) ausgebildet zur photovoltaischen Konvertierung von Licht, mit
- einem Träger mit einer Vorderfläche und Rückfläche, und
- einem ersten Halbleiterkörper (30) mit einer ersten Oberfläche (32) und einer ersten rückseitigen Fläche (34), wobei die erste rückseitige Fläche (34) auf der Vorderfläche des Trägers (20) angeordnet ist, und
- einem zweiten Halbleiterkörper (40) mit einer zweiten Oberfläche (42) und einer zweiten rückseitigen Fläche(44), wobei die zweite rückseitige Fläche (44) auf der Vorderfläche des Trägers (20) angeordnet ist, und
- die erste Oberfläche (32) des ersten Halbleiterkörpers (30) mit der zweiten rückseitigen Fläche (44) des zweiten Halbleiterkörpers (40) verschaltet ist,
- die erste Oberfläche (32) und die zweite Oberfläche (42) als Empfangsflächen für Licht ausgebildet sind, und ein elektrisch leitender Verbinder (60, 100) mit einem ersten Schenkel (62, 102) und einem zweiten Schenkel (64, 104) vorgesehen ist, und der erste Schenkel (62, 102) auf der ersten Oberfläche angeordnet, und der zweite Schenkel (64, 104) unter der zweiten rückseitigen Fläche (44) angeordnet ist,
**dadurch gekennzeichnet, dass**
die Oberfläche des als Platine ausgebildeten Trägers (20) im Bereich der ersten rückseitigen Fläche (34) eine erste Leiterbahnschiene (78) aufweist und die Oberfläche des Trägers (20) im Bereich der zweiten rückseitigen Fläche (44) die zweite Leiterbahnschiene (80) aufweist, wobei die erste Leiterbahnschiene (78) und die zweite Leiterbahnschiene (80) voneinander beabstandet sind,
und der erste Schenkel (62, 102) mit der ersten Oberfläche (32) elektrisch verschaltet ist und der zweite Schenkel (64, 104) mit der zweiten rückseitigen Fläche (44) elektrisch verschaltet ist, indem der zweite Schenkel (64, 104) in einem leitfähigen Material (70) wenigstens teilweise eingebettet ist und das leitfähige Material (70) eine stoffschlüssige Verbindung mit der zweiten rückseitigen Fläche (44) ausbildet und
zwischen der zweiten rückseitigen Fläche (44) und einer zweiten Leiterbahnschiene (80) angeordnet ist und die zweite Leiterbahnschiene (80) auf der Vorderfläche des Trägers (20) als Teil des Trägers (20) ausgebildet ist.

2. Lichtkonverter (10) nach Anspruch 1, **dadurch gekennzeichnet, dass** das leitfähige Material (70) die zweite rückseitige Fläche (44) im Wesentlichen ganzflächig benetzt und eine stoffschlüssige Verbindung zwischen dem zweiten Halbleiterkörper (40) und dem leitfähigen Material (70) ausgebildet ist und eine stoffschlüssige Verbindung zwischen dem leitfähigen Material (70) und der zweiten Leiterbahnschiene (80) ausgebildet ist.

3. Lichtkonverter (10) nach Anspruch 1 oder Anspruch 2, **dadurch gekennzeichnet, dass** zwischen dem ersten Schenkel (62, 102) und dem zweiten Schenkel (64, 104) ein Zwischenstück angeordnet ist und der Verbinder (60, 100) im Querschnitt im Wesentlichen eine stufenförmige Ausbildung aufweist.

4. Lichtkonverter (10) nach Anspruch 1 oder Anspruch 2, **dadurch gekennzeichnet, dass** der Verbinder (60, 100) mehrere erste Schenkel (62, 102) in einer kammförmigen Anordnung aufweist und jeder der ersten Schenkel (62, 102) als Stromsammler für die erste Oberfläche (32) ausgebildet ist.

5. Lichtkonverter (10) nach einem vorstehenden Anspruch, **dadurch gekennzeichnet, dass** der erste Schenkel (62, 102) mit der ersten Oberfläche (32) verschweißt und der zweite Schenkel (64. 104) mit der zweiten rückseitigen Fläche (44) verlötet ist.

6. Lichtkonverter (10) nach einem vorstehenden Anspruch, **dadurch gekennzeichnet, dass** das leitfähige Material (70) ein Lot oder ein Polymer umfasst.

7. Lichtkonverter (10) nach einem vorstehenden Anspruch, **dadurch gekennzeichnet, dass** der Verbinder (60, 100) einstückig ausgebildet und der zweite Schenkel (64, 104) wenigstens teilweise in ein Lotkissen eingebettet ist.

8. Lichtkonverter (10) nach Anspruch 7, **dadurch gekennzeichnet, dass** das leitfähige Material (70) oder das Lotkissen auf der ersten Leiterbahnschiene (78) ausgebildet ist.

9. Lichtkonverter (10) nach Anspruch 7 oder 8, **dadurch gekennzeichnet, dass** die erste rückseitige Fläche (34) und die zweite rückseitige Fläche (44) stoffschlüssig mit den Lotkissen verbunden sind.

10. Lichtkonverter (10) nach einem der Ansprüche 7 bis 9, **dadurch gekennzeichnet, dass** die erste rückseitige Fläche (34) und die zweite rückseitige Fläche (44) nur mit einem einzelnen Lotkissen und elektrisch leitenden Verbindern (60, 100) verbunden sind und die laterale Ausdehnung des jeweiligen Lotkissens kleiner als die laterale Ausdehnung des jeweiligen Halbleiterkörpers (30, 40, 50) ist.

11. Lichtkonverter (10) nach einem vorstehenden Anspruch, **dadurch gekennzeichnet, dass** die erste rückseitige Fläche (35) und die zweite rückseitige Fläche (45) in einem Randbereich derart ausgebildet sind, dass der Randbereich nicht mit Lot benetzt.

12. Lichtkonverter (10) nach einem vorstehenden Anspruch, **dadurch gekennzeichnet, dass** der erste Halbleiterkörper (30) eine quaderförmige Ausbildung aufweist und die Seitenflächen (34) des ersten Halbleiterkörpers (30) mit einem Lötstoppmittel, vorzugsweise einem elektrischen Isolator versehen sind.

13. Lichtkonverter (10) nach Anspruch 12, **dadurch gekennzeichnet, dass** das Lötstoppmittel in einem umlaufenden Randabschnitt auf der ersten Oberfläche (32), der zweiten Oberfläche (42), der ersten rückseitigen Fläche (35) und der zweiten rückseitigen Fläche (45) angeordnet ist.

14. Lichtkonverter (10) nach Anspruch 12, **dadurch gekennzeichnet, dass** der Verbinder (60, 100) auf mindestens einer Seite teilflächig vorzugsweise mindestens an der Unterseite mit einem Lötstoppmittel beschichtet ist.

15. Lichtkonverter (10) nach einem der Ansprüche 12 bis 14, **dadurch gekennzeichnet, dass** das Lötstoppmittel ein Polymer umfasst.

16. Lichtkonverter (10) nach einem der Ansprüche 12 bis 14, **dadurch gekennzeichnet, dass** mindestens ein Lötstoppmittel ein Metalloxid, vorzugsweise eine Metallschicht mit einer oberflächlichen Metalloxidschicht umfasst.

17. Lichtkonverter (10) nach einem vorstehenden Anspruch, **dadurch gekennzeichnet, dass** der erste Halbleiterkörper (30) und der zweite Halbleiterkörper (40) seriell verschaltet sind, so dass bei einem Einfall von Licht auf die Empfangsflächen des ersten Halbleiterkörpers (30) und des zweiten Halbleiterkörpers (40) die photovoltaisch erzeugten Spannungen addiert werden.

18. Verwendung des Lichtkonverters (10) nach einem der vorstehenden Ansprüche in einer Konzentratoranordnung zur Erzeugung von Strom.

19. Verwendung des Lichtkonverters (10) nach Anspruch 18, **dadurch gekennzeichnet, dass** die Empfangsflächen in einer Brennfläche einer das Sonnenlicht konzentrierenden Optik angeordnet sind.

## Claims

1. Light converter (10) constructed for photovoltaic conversion of light, comprising
- a support with a front surface and back surface,
- a first semiconductor body (30) with a first top surface (32) and a first rear surface (34), wherein the first rear surface (34) is arranged on the front surface of the support (20), and
- a second semiconductor body (40) with a second top surface (42) and a second rear surface (44), wherein the second rear surface (44) is arranged on the front surface of the support (20),
wherein the first top surface (32) of the first semiconductor body (30) is electrically connected with the second rear surface (44) of the second semiconductor body (40) and
- the first top surface (32) and the second top surface (42) are constructed as receiving surfaces for light, an electrically conductive connector (60, 100) with a first limb (62, 102) and a second limb (64, 104) being provided and the first limb (62, 102) being arranged on the first top surface and the second limb (64, 104) under the second rear surface (44),
**characterised in that**
the top surface of the support (20), which is constructed as a circuitboard, has a first conductor track rail (78) in the region of the first rear surface (34) and the top surface of the support (20) has a second conductor track rail (80) in the region of the second rear surface (44), wherein the first conductor track rail (78) and the second conductor track rail (80) are spaced from one another,
and the first limb (62, 102) is electrically connected with the first top surface (32) and the second limb (64, 104) is electrically connected with the second rear surface (44) **in that** the second limb (64, 104) is at least partly embedded in a conductive material (7) and the conductive material (70) forms a connection by material couple with the second rear surface (44) and is arranged between the second rear surface (44) and the second conductor track rail (80), the second conductor track rail (80) being formed on the front surface of the support (20) as part of the support (20).

2. Light converter (10) according to claim 1, **characterised in that** the conductive material (70) is applied to the second rear surface (44) over substantially the whole area and a connection by material couple is formed between the second semiconductor body (40) and the conductive material (70) and a connection by material couple is formed between the conductive material (70) and the second conductor track rail (80).

3. Light converter (10) according to claim 1 or 2, **characterised in that** an intermediate member is arranged between the first limb (62, 102) and the second limb (64, 104) and the connector (60, 100) has a substantially step-shaped form in cross-section.

4. Light converter (10) according to claim 1 or 2, **characterised in that** the connector (60, 100) has a plurality of first limbs (62, 102) in a comb-shaped arrangement and each of the first limbs (62, 102) is constructed as a current collector for the first top surface (32).

5. Light converter (10) according to any one of the preceding claims, **characterised in that** the first limb (62, 102) is welded to the first top surface (32) and the second limb (64, 104) is soldered to the second rear surface (44).

6. Light converter (10) according to any one of the preceding claims, **characterised in that** the conductive material (70) comprises a solder or polymer.

7. Light converter (10) according to any one of the preceding claims, **characterised in that** the connector (60, 100) is of integral construction and the second limb (64, 104) is at least partly embedded in a solder cushion.

8. Light converter (10) according to claim 7, **characterised in that** the conductive material (70) or the solder cushion is formed on the first conductor track rail (78).

9. Light converter (10) according to claim 7 or 8, **characterised in that** the first rear surface (34) and the second rear surface (44) are connected with the solder cushion by material couple.

10. Light converter (10) according to any one of claims 7 to 9, **characterised in that** the first rear surface (34) and the second rear surface (44) are connected only with a single solder cushion and electrically conductive connectors (60, 100) and the lateral dimension of the respective solder cushion is less than the lateral dimension of the respective semiconductor body (30, 40, 50).

11. Light converter (10) according to any one of the preceding claims, **characterised in that** the first rear surface (35) and the second rear surface (45) are so constructed in an edge region that solder is not applied to the edge region.

12. Light converter (10) according to any one of the preceding claims, **characterised in that** the first semiconductor body (30) has a block-shaped construction and the side surfaces (34) of the first semiconductor body (30) are provided with a solder stop means preferably an electrical insulator.

13. Light converter (10) according to claim 12, **characterised in that** the solder stop means is arranged in an encircling edge section on the first top surface (32), the second top surface (42), the first rear surface (35) and the second rear surface (45).

14. Light converter (10) according to claim 12, **characterised in that** the connector (60, 100) is coated over part of the area on at least one side, preferably at least at the underside, with a solder stop means.

15. Light converter (10) according to any one of claims 12 to 14, **characterised in that** the solder stop means comprises a polymer.

16. Light converter (10) according to any one of claims 12 to 14, **characterised in that** the at least one solder stop means comprises a metal oxide, preferably a metal layer with a top surface metal oxide coating.

17. Light converter (10) according to any one of the preceding claims, **characterised in that** the first semiconductor body (30) and the second semiconductor body (40) are connected in series so that in the case of incidence of light on the receiving surfaces of the first semiconductor body (30) and the second semiconductor body (40) the voltages generated photovoltaically are summated.

18. Use of the light converter (10) according to any one of the preceding claims in a concentrator arrangement for generating current.

19. Use of the light converter (10) according to claim 18, **characterised in that** the receiving surfaces are arranged at a focal surface of an optical system concentrating the sunlight.

## Revendications

1. Convertisseur de lumière (10) configuré en vue de la conversion photovoltaïque de lumière, avec
- un support avec une face avant et une face arrière, et
- un premier corps semi-conducteur (30) avec une première surface (32) et une première face arrière (34), dans lequel la première face arrière (34) est disposée sur la face avant du support (20), et
- un deuxième corps semi-conducteur (40) avec une deuxième surface (42) et une deuxième face arrière (44), dans lequel la deuxième face arrière (44) est disposée sur la face avant du support (20), et
- la première surface (32) du premier corps semi-conducteur (30) est connectée à la deuxième face arrière (44) du deuxième corps semi-conducteur (40),
- la première surface (32) et la deuxième surface (42) sont conçues sous forme de faces de réception pour la lumière, et il est prévu un connecteur électriquement conducteur (60, 100) avec une première branche (62, 102) et une deuxième branche (64, 104), et la première branche (62, 102) est disposée sur la première surface, et la deuxième branche (64, 104) est disposée en dessous de la deuxième face arrière (44),
**caractérisé en ce que**
la surface du support réalisé sous forme de platine (20) présente dans la zone de la première face arrière (34) un rail de piste conductrice (78) et la surface du support (20) présente dans la zone de la deuxième face arrière (44) le deuxième rail de piste conductrice (80), le premier rail de piste conductrice (78) et le deuxième rail de piste conductrice (80) étant espacés l'un de l'autre, et
la première branche (62, 102) est électriquement connectée à la première surface (32) et la deuxième branche (64, 104) est électriquement connectée à la deuxième face arrière (44), par le fait que la deuxième branche (64, 104) est au moins en partie noyée dans un matériau conducteur (70) et que le matériau conducteur (70) forme une liaison de matière avec la deuxième face arrière (44) et
est disposé entre la deuxième face arrière (44) et un deuxième rail de piste conductrice (80) et le deuxième rail de piste conductrice (80) est disposé sur la face avant du support (20) comme faisant partie du support (20).

2. Convertisseur de lumière (10) selon la revendication 1, **caractérisé en ce que** le matériau conducteur (70) mouille la deuxième face arrière (44) essentiellement sur toute la surface et une liaison de matière est réalisée entre le deuxième corps semi-conducteur (40) et le matériau conducteur (70) et une liaison de matière est réalisée entre le matériau conducteur (70) et le deuxième rail de piste conductrice (80).

3. Convertisseur de lumière (10) selon la revendication 1 ou la revendication 2, **caractérisé en ce qu'**une pièce intermédiaire est disposée entre la première branche (62, 102) et la deuxième branche (64, 104) et le connecteur (60, 100) présente essentiellement en section transversale une configuration de forme étagée.

4. Convertisseur de lumière (10) selon la revendication 1 ou la revendication 2, **caractérisé en ce que** le connecteur (60, 100) présente plusieurs premières branches (62, 102) agencées en forme de peigne et chacune des premières branches (62, 102) est réalisée sous forme de collecteur de courant pour la première surface (32).

5. Convertisseur de lumière (10) selon l'une quelconque des revendications précédentes, **caractérisé en ce que** la première branche (62, 102) est soudée à la première surface (32) et la deuxième branche (64, 104) est brasée à la deuxième face arrière (44).

6. Convertisseur de lumière (10) selon l'une quelconque des revendications précédentes, **caractérisé en ce que** le matériau conducteur (70) comprend un métal de brasage ou un polymère.

7. Convertisseur de lumière (10) selon l'une quelconque des revendications précédentes, **caractérisé en ce que** le connecteur (60, 100) est formé d'une seule pièce et la deuxième branche (64, 104) est noyée au moins en partie dans un coussin de brasage.

8. Convertisseur de lumière (10) selon la revendication 7, **caractérisé en ce que** le matériau conducteur (70) ou le coussin de brasage est formé sur le premier rail de piste conductrice (78).

9. Convertisseur de lumière (10) selon la revendication 7 ou 8, **caractérisé en ce que** la première face arrière (34) et la deuxième face arrière (44) sont reliées par une liaison matérielle au coussin de brasage.

10. Convertisseur de lumière (10) selon l'une quelconque des revendications 7 à 9, **caractérisé en ce que** la première face arrière (34) et la deuxième face arrière (44) ne sont reliées qu'à un seul coussin de brasage et à des connecteurs électriquement conducteurs (60, 100) et l'extension latérale du coussin de brasage respectif est plus petite que l'extension latérale du corps semi-conducteur respectif (30, 40, 50).

11. Convertisseur de lumière (10) selon l'une quelconque des revendications précédentes, **caractérisé en ce que** la première face arrière (35) et la deuxième face arrière (45) sont configurées dans une zone de bord de telle manière que la zone de bord ne soit pas mouillée par le métal de brasage.

12. Convertisseur de lumière (10) selon l'une quelconque des revendications précédentes, **caractérisé en ce que** le premier corps semi-conducteur (30) présente une forme parallélépipédique et les faces latérales (34) du premier corps semi-conducteur (30) sont munies d'un moyen d'arrêt de brasure, de préférence d'un isolateur électrique.

13. Convertisseur de lumière (10) selon la revendication 12, **caractérisé en ce que** le moyen d'arrêt de brasure est disposé dans une partie marginale périphérique sur la première surface (32), la deuxième surface (42), la première face arrière (35) et la deuxième face arrière (45).

14. Convertisseur de lumière (10) selon la revendication 12, **caractérisé en ce que** le connecteur (60, 100) est revêtu d'un moyen d'arrêt de brasure sur au moins un côté, sur une partie de la surface, de préférence au moins sur le côté inférieur.

15. Convertisseur de lumière (10) selon l'une quelconque des revendications 12 à 14, **caractérisé en ce que** le moyen d'arrêt de brasage comprend un polymère.

16. Convertisseur de lumière (10) selon l'une quelconque des revendications 12 à 14, **caractérisé en ce qu'**au moins un moyen d'arrêt de brasure comprend un oxyde métallique, de préférence une couche de métal avec une couche superficielle d'oxyde métallique.

17. Convertisseur de lumière (10) selon l'une quelconque des revendications précédentes, **caractérisé en ce que** le premier corps semi-conducteur (30) et le deuxième corps semi-conducteur (40) sont connectés en série, de telle manière que lors d'une incidence de lumière sur les faces de réception du premier corps semi-conducteur (30) et du deuxième corps semi-conducteur (40), les tensions produites par voie photovoltaïque soient additionnées.

18. Utilisation du convertisseur de lumière (10) selon l'une quelconque des revendications précédentes dans un dispositif concentrateur pour la production de courant.

19. Utilisation du convertisseur de lumière (10) selon la revendication 18, **caractérisée en ce que** les faces de réception sont disposées dans un plan focal d'une optique concentrant la lumière solaire.
